(19) Europäisches Patentamt
European Patent Office
Office européen des brevets

(11) Publication number: **0 252 739 B1**

(12) # EUROPEAN PATENT SPECIFICATION

(45) Date of publication of patent specification: **06.10.93**

(51) Int. Cl.5: **H01L 21/68**

(21) Application number: **87306075.0**

(22) Date of filing: **09.07.87**

(54) **Adhesive sheets for sticking wafers thereto.**

(30) Priority: **09.07.86 JP 161682/86**
**26.02.87 JP 43744/87**

(43) Date of publication of application:
**13.01.88 Bulletin 88/02**

(45) Publication of the grant of the patent:
**06.10.93 Bulletin 93/40**

(84) Designated Contracting States:
**DE FR GB NL**

(56) References cited:
**EP-A- 0 134 606**
**EP-A- 0 135 416**
**EP-A- 0 142 783**
**EP-A- 0 150 882**
**US-A- 3 970 494**

**PATENT ABSTRACTS OF JAPAN, vol. 9, no. 1 (C-259)[1724], 5th January 1985; & JP-A-59 157 162 (DAINIPPON INSATSU K.K.) 06-09-1984**

(73) Proprietor: **LINTEC Corporation**
**Honcho 23-23**
**Itabashi-ku**
**Tokyo(JP)**

(72) Inventor: **Ebe,Kazuyoshi**
**1375-19 Shimonoda,Shiraokamachi**
**Minamisaitamagun,Saitama, 349-02(JP)**
Inventor: **Narita,Hiroaki**
**1-502 Yoshikawadanchi**
**1-chome,Yoshikawacho**
**Kita-Katsushikagun,Saitama 335(JP)**
Inventor: **Taguchi,Katsuhisa**
**14-18 Chuo 2-chome,Warabi-shi**
**Saitama 335(JP)**
Inventor: **Akeda,Yoshitaka**
**7-3 Tsuji 7-chome,Urawa-shi**
**Saitama 336(JP)**
Inventor: **Saito,Takanori**
**318-310 Uekomachi,Oomiya-shi**
**Saitama 330(JP)**

(74) Representative: **Matthews, Derek Peter et al**
**Frank B. Dehn & Co.**
**Imperial House**
**15-19 Kingsway**
**London WC2B 6UZ (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 252 739 B1

## Description

### FIELD OF THE INVENTION

This invention relates to adhesive sheets which are applied to the face side of semiconductor wafers in the course of grinding the reverse side of the semiconductor wafers having formed patterns on the face side thereof, and more particularly to adhesive sheets for sticking wafers thereto which are used when the reverse side of semiconductor wafers having formed patterns by etching or the like technique on the face side thereof are ground.

### BACKGROUND OF THE INVENTION

On the face side of wafers of semiconductors such as silicon, gallium-arsenic, etc., there are formed patterns by the etching or lift-off technique. Subsequently, an adhesive sheet is applied to the face side of the wafers having formed patterns thereon and usually the thus applied wafers are subjected, as they are, on the reverse side thereof to grinding treatment by means of a grinder or the like. The purpose of subjecting the reverse side of wafers having formed patterns on the face side thereof to grinding treatment is firstly to remove a film of oxide from said reverse side as the oxide film is sometimes formed thereon during the etching step, and secondly to adjust the pattern-formed wafers in thickness to a desired level.

In this connection, the grinding treatment of the reverse side of wafers having formed patterns on the face side thereof is carried out while washing said reverse side with purified water in order to remove the resulting grindings as well as heat generated at the time of grinding. Accordingly, adhesive sheets applied to the face side of wafers in the grinding treatment of the reverse side of the wafers to protect the patterns formed on the face side thereof must have water resistance. For this reason, solvent-type acrylic adhesives have widely been used in adhesive sheets used for the purpose intended.

After the completion of the grinding treatment of the reverse side of wafers conducted in the manner now described, the adhesive sheets applied are stripped off therefrom. In that case, however, there were observed some cases wherein acrylic adhesives or the like of the adhesive sheets used remained attached to the face side of the wafers having formed patterns thereon. On that account, the adhesives thus attached to the face side of the wafers had to be removed therefrom.

Removal of the acrylic adhesives or the like attached to the face side of wafers has been carried out hitherto by washing said face side with chlorine-containing type organic solvents such as Trichlene, followed by cleaning with purified water. Because of the risk of exerting adverse effects on the human body, however, chlorine-containing solvents such as Trichlene used for washing the face side of wafers are desirably not used. Furthermore, the above-mentioned process of washing the face side of wafers has been found to be a time-consuming job since the process comprises two steps, the first one of which is the washing of said face side with organic solvents such as Trichlene, and the second is the cleaning of the washed face side with purified water. Under these circumstances, it would be advantageous for the washing process of the face side of wafers to be completed in a single step without any danger to the human body by using adhesives attached to the face side of wafers which can be removed by cleaning with purified water in place of chlorine-containing type organic solvents. As mentioned previously, however, the grinding process of the reverse side of wafers is carried out while washing said reverse side with purified water. If, therefore, water-soluble adhesives widely used heretofore as adhesives for adhesive sheets are used in the adhesive sheets as originally intended herein, it follows, as a natural consequence, that the problem is created that the water-soluble adhesive dissolves in the purified water during the above-mentioned grinding process and the resulting grindings present in said purified water enter into the space formed between the face side of wafers and adhesive sheet, thereby destroying the patterns formed on said face side.

European Patent Application No. 157508 discloses a thin adhesive sheet which is used to protect the surface of a semi-conductor wafer during polishing or separation of the wafer into individual I.C. chips. The adhesive used in EP-A-157508 is photosensitive and not water-swellable.

The present invention is intended to solve at a single stroke such problems associated with the prior art as mentioned above. By applying an adhesive sheet comprising a water-swellable water-soluble adhesive to the patterned face side of a wafer, a temporary structure or combination can be formed. Such a temporary structure can be subjected to grinding treatment where the reverse side of the wafer is ground, and has the advantage that the adhesive of the adhesive sheet can be removed by cleaning with water, when it remains attached to the face side of wafers after the completion of the grinding treatment. Thus, use of organic solvents such as Trichlene are not required and accordingly there is no health hazard which could affect the human body. Moreover, removal of the adhesive, which is occasionally attached to the face side of wafers,

can be effected by a single step.

The present invention thus provides a temporary structure comprising a semiconductor wafer having a patterned face and attached thereto an adhesive sheet for protecting said patterned face during grinding of the reverse side of said wafer, characterised in that said adhesive sheet comprises a base sheet and a water-swellable water-soluble adhesive.

In the adhesive sheets of the invention as mentioned above, a water-swelling water-soluble adhesive is applied as an adhesive layer to the base of said adhesive sheet. Therefore, even when the adhesive remains attached to the face side of wafers after stripping off the adhesive sheets from the wafers following completion of grinding the reverse side of the wafers, the attached adhesive can be removed from the face side by cleaning with water without using organic solvents such as Trichlene. Accordingly, there is no possibility of exerting adverse effects on the human body and, moreover, the adhesive attached to the face side of wafers can be removed therefrom by a single step.

The present invention further provides a process for grinding the reverse side of a wafer said process comprising:

i) forming a temporary structure as hereinbefore described;
ii) grinding the reverse side of said wafer with water spraying;
iii) stripping off said adhesive sheet after completion of grinding; and where necessary
iv) removing any residual adhesive by water washing.

The adhesive sheets for sticking wafers thereto (hereinafter called "the wafer-sticking adhesive sheets" for brevity's sake) obtained in accordance with the present invention are illustrated below in more detail.

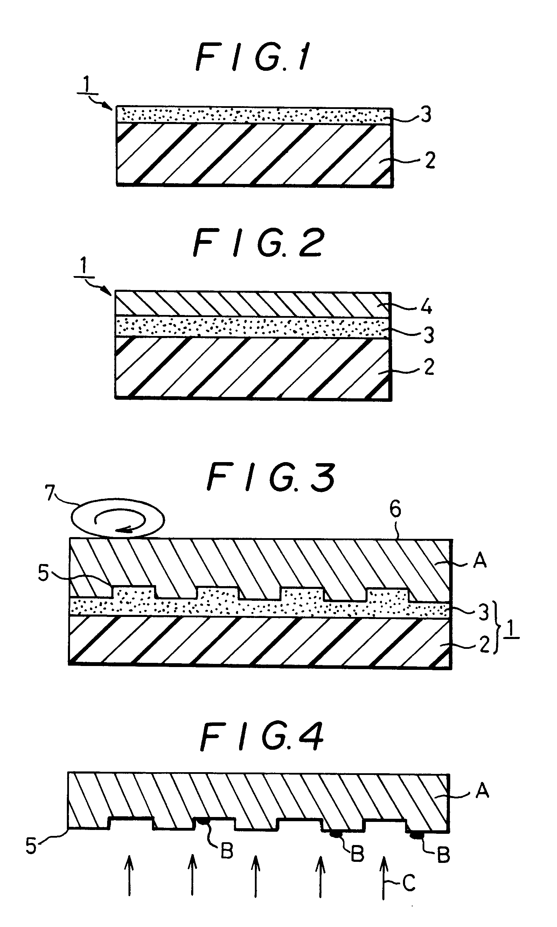

The wafer-sticking adhesive sheet 1 of the invention comprises a base 2 and an adhesive layer 3 formed by applying an adhesive to on the surface of said base 2, as schematically illustrated in the accompanying Fig. 1. In order to protect this adhesive layer 3 before the adhesive sheet 1 is used, it is preferable to apply temporarily a release sheet 4 to the face side of the adhesive layer 3 in the manner as shown in Fig. 2.

The wafer-sticking adhesive sheets of the invention can be in any forms such as tape, labels and the like. Materials excellent in water resistance as well as in heat resistance, particularly films of synthetic resins, are suitable as those for the base 2.

Examples of the materials usable as the base 2 include films of synthetic resins such as polyethylene, polypropylene, polyvinyl chloride, polyethylene terephthalate, polybutylene terephthalate, polybutene, polybutadiene, polyurethane, polymethyl pentene and ethylene-vinyl acetate copolymer. Furthermore, cross-linked polyolefin or ethylene-methacrylic acid copolymer film can also be used as the base 2.

In a preferred embodiment of the present invention, a water-swelling adhesive is applied as the adhesive layer 3 to the base as exemplified above.

The water-swelling adhesive as used herein is preferably an adhesive which essentially consists of a copolymer having as its recurring structural units an unsaturated carboxylic acid-containing monomer and acrylic ester type monomer, in which the copolymeric units are mutually interlocked or cross-linked, said adhesive undergoing finite swelling on contact with water. Where it is necessary to vary water-solubility or adhesion characteristics of the adhesive used from the practical point of view, hydrophilic plasticizers or hydrophilic epoxy compounds commonly adopted for the purpose intended may be used in combination with the above-mentioned water-swelling adhesive.

Usable as the water-swelling adhesive in the present invention are those disclosed, for example, in Japanese Patent Publication No. 23294/1974.

That is, the disclosed adhesives are composed of (A) one or two or more nonionic surface active agents having polyoxyethylene groups as their hydrophilic components, and (B) one or two or more copolymers composed of 40-99 mol% of one or two or more recurring structural units represented by the following formula (I) and 60-1 mol% of one or two or more recurring structural units represented by the following formula (II), said copolymer or copolymers being cross-linked, if necessary, with a crosslinker such as zinc acetate or magnesium chloride which reacts with the carboxyl group of the component (B). In that case, alkaline compounds such as potassium hydroxide may be allowed to coexist with the crosslinker at the time of cross-linking.

Formula (I)

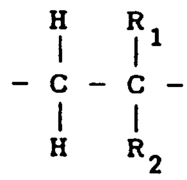

wherein $R_1$ is hydrogen, chlorine or lower alkyl and $R_2$ is hydrogen, chlorine, lower alkyl or a group $-OCOR_3$, $-OR_3$, $-COOR_3$,

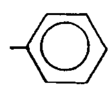 , 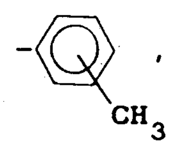 ,

$-CN$, $-CONH_2$, $-CONHCH_2OH$, $-CH_2OH$, $-C_2H_4OH$, $-OH$ or

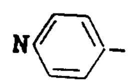,

in which $R_3$ is alkyl of 1-8 carbon atoms (lower alkyl groups as referred to herein are preferably $C_{1-4}$).

Formula (II)

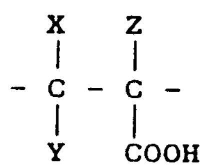

wherein X, Y and Z, which may be the same or different, are each hydrogen, chlorine, lower alkyl or the group of $-COOR_4$, $-COOH$, $-CH_2COOH$ or $-CH_2COOR_4$, in which $R_4$ is alkyl of 1-4 carbon atoms.

Usable as the component (A), a nonionic surface active agent having the polyoxyethylene group as its hydrophilic component, are those having the following formulas as exemplified below.

(i) $HO(C_2H_4O)_a(C_3H_6O)_b(C_2H_4O)_cH$

wherein a, b and c are each an integer of 20-80.

(ii) $RA(C_2H_4O)_eH$

wherein R is alkyl of 6-8 carbon atoms, alkylphenyl having alkyl of 4-20 carbon atoms or the group

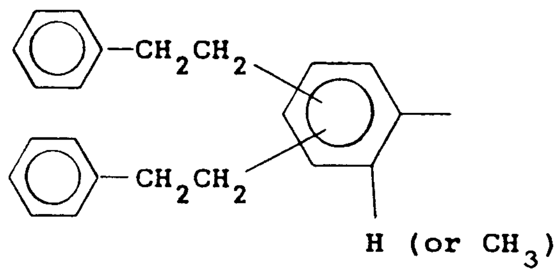

A is oxygen, sulfur or the group -COO, -CONH, $CON(C_2H_4O)_eH$, $PO_4H$ or $PO_4(C_2H_4O)_eH$, the symbols e, which may be the same or different, each representing an integer of 2-80.

(iii)

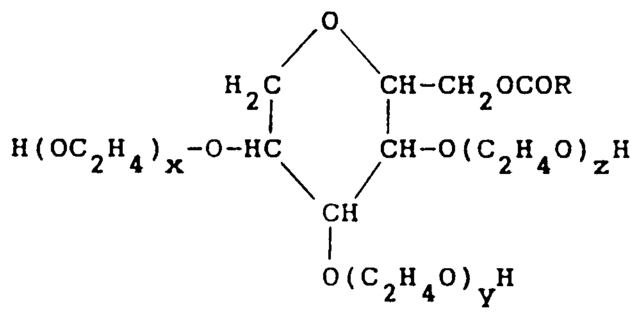

wherein R is alkyl of 6-18 carbon atoms, and x, y and z are each an integer of 2-40.

Examples of the above-mentioned nonionic surface active agent used as the component (A) include, for example, polyethylene glycol nonylphenyl ether, polyethylene glycol sorbitan monooleyl ester, polyethylene glycol lauryl ether, block copolymers of polyethylene glycol and polypropylene glycol, polyethylene glycol laurylphenyl ether and polyethylene glycol t-butylphenyl ether.

The recurring structural units represented by the aforementioned formula (I) in the component (B) are introduced from such monomers as, for example, vinyl esters such as vinyl acetate, acrylic esters such as ethyl acrylate, methacrylic esters such as ethyl methacrylate, ethylene, styrene, methyl vinyl ether, vinyl chloride and acrylonitrile. The recurring structural units represented by the aforementioned formula (II) in the component (B) are introduced from monomers having carboxyl groups, for example, acrylic acid, methacrylic acid, crotonic acid, itaconic acid, maleic acid, fumaric acid, aconitic acid, monoalkylmaleic acid, monoalkylfumaric acid and monoalkylitaconic acid.

The above-mentioned components (A) and (B) must be compatible with each other and, moreover, the adhesives obtained therefrom must be water-swelling. On that account, a quantitative relationship between the components (A) and (B) is stipulated.

Depending on circumstances, glycidyl ether type epoxy compounds can also be used together with the above-mentioned components (A) and (B).

As the water-swelling adhesive used in the present invention, there can also be used such adhesives as disclosed in Japanese Laid-Open-to-Public Publn. No. 157162/1984.

That is, the disclosed adhesives are composed essentially of such components as (A) a water-soluble polymer and (B) a (meth)acrylic ester monomer which, when polymerized, gives a water-swelling polymer.

Concretely, the above-mentioned component (A) is derived from a (meth)acrylic ester monomer represented by the formula

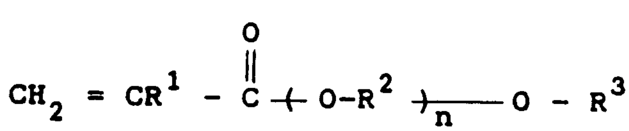

wherein $R^1$ is hydrogen or methyl, $R^2$ is alkylene of 2-4 carbon atoms, $R^3$ is alkyl of 1 or more carbon atoms, and n is an integer of 1 or more, (meth) acrylic acid, (meth) acrylic ester, Vinylpyrrolidone, acrylamide, dimethylaminoethyl (meth) acrylate, diethylaminoethyl (meth) acrylate, or vinyl methyl ether.

According to circumstances, usable as the water-soluble polymer of (A) mentioned above are polymers obtained by copolymerizing such a monomer as mentioned above with acrylic ester, vinyl acetate or styrene in an amount of up to 30 parts by weight.

As the component (B) mentioned above, there are used, for example, (meth)acrylic ester monomers, dimethylaminoethyl(meth)acrylates and diethylaminoethyl(meth)acrylates.

Further, usable as the water-swelling adhesives in the present invention are such adhesives as disclosed in Japanese Laid-Open-to-Public Publn. No. 70077/1981.

That is, the disclosed water-swelling adhesives are composed essentially of such components as (A) a salt of a copolymer obtained by neutralizing the carboxyl group in a copolymer comprising 10-40 mol% of a carboxyl-containing monomer, 60-90 mol% of (meth)acrylic alkyl ester having alkyl of 4 or more carbon atoms and 0-20 mol% of vinyl monomer other than the above-mentioned monomers and (B) a hydrophilic compound represented by the formula $R_1O(R_2O)_nR_3$ wherein $R_1$ is alkyl of 1-4 carbon atoms, $R_2$ is alkylene of 2-4 carbon atoms, $R_3$ is hydrogen, alkyl of 1-4 carbon atoms or acetyl, and n is an integer of 1-6. Where the adhesive sheet 1 having coated thereon such adhesive as mentioned above to form an adhesive layer has been applied to the pattern-formed face side of said wafer A and the reverse side of said wafer A is subjected to grinding treatment while spraying purified water thereover, swelling equilibrium is established after absorption of water and an effect of preventing the sprayed water from permeating into the adhesive layer up to the pattern portions is obtained. By virtue of this effect, no wafer grindings present in the purified water being sprayed enter in between the pattern-formed face side of the wafer A and adhesive sheet 1, thus the patterns formed on the face side of the wafer A can sufficiently be protected.

In the accompanying drawings, Figs. 1 and 2 are sectional views of the adhesive sheet of the present invention, and Figs. 3 and 4 are explanatory diagrams showing the grinding of the reverse side of wafer, wherein:

1...Adhesive Sheet
2...Base
3...Adhesive layer
A...Wafer
B...Remaining adhesive
C...Wafer

A method for the application of the adhesive sheet 1 of the present invention is illustrated hereinafter.

Where a release sheet 4 is provided on the top of an adhesive sheet 1 for sticking wafers according to the present invention, said release sheet 4 is first removed therefrom, and a wafer A, the reverse side of which is to be subjected later to grinding treatment, is stuck to an adhesive layer 3. In that case, the wafer A is stuck to the adhesive layer 3 so that the face side of said wafer having formed patterns 5 thereon is in contact with said adhesive layer 3.

At a stage as mentioned above, the reverse side 6 of the wafer A is ground by means of a grinder 7, thereby removing an oxide film formed thereon and, at the same time, adjusting the wafer A in thickness to a desired level. In that case, the resulting wafer grindings are washed away by spraying purified water over the wafer A and, at the same time, heat generated at the time of grinding is removed.

After the completion of the grinding, the adhesive sheet 1 is then stripped off from the wafer A. In that case, a water-soluble adhesive or the like sometimes attaches to the face side of the wafer A having formed thereon the patterns 5. The attached adhesives B have a sufficient water-solubility and hence can be simply washed away with the purified water C.

In this manner, since the water-swelling adhesives are used to form the adhesive layer in the adhesive sheets for sticking wafers thereto of the present invention, even when the adhesives attach to the face side of wafers, the attached adhesives can be removed therefrom by cleaning with purified water without using organic solvents such as Trichlene, accordingly there is no risk at all of exerting adverse effects on the human body. In accordance with the present invention, moreover, it is sufficient to clean the face side of wafers, to which the adhesives attach, with the purified water, thus the cleaning operation can be carried out by a single step, whereas in the prior art adhesive sheets used for the same purpose, there was need of two steps for the cleaning operation wherein the face side of wafers, to which the adhesives were attached, was washed with organic solvents such as Trichlene, followed by cleaning with purified water.

Furthermore, in the adhesive sheet 1 for sticking wafers thereto of the present invention, there is no possibility that wafer grindings enter in between the face side of wafers and adhesive sheet at the time of grinding the reverse side of the wafer A because the adhesive sheet 1 having a sufficient adhesion force is applied to the face side of the wafer A, and the wafer grindings cannot enter in between the face side of wafers and adhesive sheet and thereby destroy the patterns formed on the face side of wafers.

EFFECT OF THE INVENTION

The wafer-sticking adhesive sheets of the present invention are adhesive sheets to be applied to the face side of wafers when the reverse side of said wafers is subjected to grinding treatment, and are coated on the surface thereof with water-swelling adhesives to form an adhesive layer. Therefore, when the adhesive sheet is stripped off from the face side of wafers after the completion of the grinding treatment of the reverse side of said wafers, the adhesive which remains attached, if any, to the face side of the wafers can be removed therefrom by cleaning with water without using organic solvents such as Trichlene. Accordingly, there is no risk of exerting adverse effects on the human body and, moreover, the adhesive, which is occasionally attached to the face side of wafers can be removed by a single step.

EXAMPLE 1

On a polyester film of 50 $\mu m$ in thickness was coated at a coating weight (dry basis) of 40 $g/m^2$ an acrylic type water-swelling adhesive composed of (i) a copolymer of ethyl acrylate, vinyl acetate and methacrylic acid and (ii) polyethylene glycol lauryl ether, said copolymer having been cross-linked with zinc acetate in the presence of potassium hydroxide. Thus, there was obtained an adhesive sheet having an adhesion force of 90 g/25 mm at 180° as measured according to JISZ-0237.

The adhesive surface of the thus obtained adhesive sheet was applied by means of a press roll with a load of 1 kg to the face side of a wafer having formed patterns thereon. This test specimen was fixed accurately to a grinding apparatus so that the reverse side of the wafer is turned upward, and said reverse side was ground for 5 minutes under a water pressure of 30 $kg/cm^2$ with water-spraying.

Thereafter, the adhesive sheet was stripped off from the wafer, and said wafer was observed on the face side thereof, after cleaning and drying, by means of an electron microscope.

The results obtained are shown in Table 1.

COMPARATIVE EXAMPLE 1

Following the same procedure as described in Example 1, a solvent type acrylic adhesive (composed of 100 parts by weight of a copolymer of n-butyl acrylate, vinyl acetate and acrylic acid, having a molecular weight of 300,000, and 10 parts by weight of an isocyanate curing agent) was applied to the polyester film to obtain an adhesive sheet having likewise an adhesion force of 85 g/25 mm at 180°.

The adhesive sheet thus obtained was applied to the face side of the wafer in the same manner as in Example 1 and the same observation was conducted.

The results are shown in Table 1.

**Table 1**

| | Permeation into interface of water | Adhesive remaining on the face side of wafer * | | |
|---|---|---|---|---|
| | | After stripping adhesive sheet | After cleaning with purified water | After washing with Trichlene |
| Example 1 | None | Slightly observed | None | |
| Comparative Example 1 | None | Slightly observed | Slightly observed | None |

* Electron microscope Magnification 5000 times

## Claims

1. A temporary structure comprising a semiconductor wafer having a patterned face and attached thereto an adhesive sheet for protecting said patterned face during grinding of the reverse side of said wafer, characterised in that said adhesive sheet comprises a base sheet and a water-swellable water-soluble adhesive.

2. A structure as claimed in claim 1 wherein said base sheet is polyethylene, polypropylene, polyvinyl chloride, polyethylene terephthalate, polybutylene terephthalate, polybutene, polybutadiene, polyurethane, polymethylpentene, ethylene-vinyl acetate copolymer, cross-linked polyolefin or ethylene-methacrylic acid copolymer.

3. A structure as claimed in either of claims 1 and 2 wherein said adhesive comprises (A) one or two or more nonionic surface active agents having ethylene oxide groups as their hydrophilic components, and (B) one or two or more copolymers composed of 40-99mol% of one or two or more recurring structural units represented by the following formula (I) and 60-1mol% of one or two or more recurring structural units represented by the following formula (II), said copolymer or copolymers being cross-linked, if necessary, with a crosslinker such as zinc acetate or magnesium chloride which reacts with the carboxyl group of the component (B);

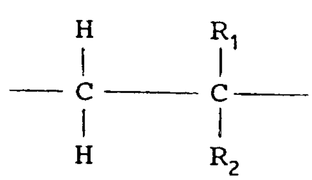

(I)

wherein $R_1$ is hydrogen, chlorine or lower alkyl and $R_2$ is hydrogen, chlorine, lower alkyl or a group $-OCOR_3$, $-OR_3$, $-COOR_3$,

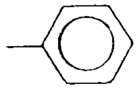 , 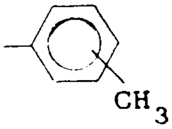 ,

$-CN$, $-CONH_2$, $-CONHCH_2OH$, $-CH_2OH$, $-C_2H_4OH$, $-OH$, or

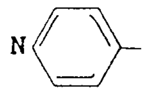 ,

in which $R_3$ is alkyl of 1-8 carbon atoms;

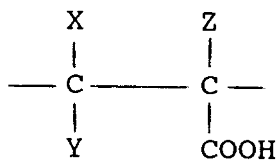 (II)

wherein X, Y and Z, which may be the same or different are each hydrogen, chlorine, lower alkyl or the group of $-COOR_4$, $-COOH$, $-CH_2COOH$ or $-CH_2COOR_4$, in which $R_4$ is an alkyl of 1-4 carbon atoms.

**4.** A structure as claimed in claim 3 wherein the nonionic surface active agents are

(i) $HO(C_2H_4O)_a(C_3H_6O)_b(C_2H_4O)_cH$

wherein a, b and c are each an integer of 20-80

(ii) $RA(C_2H_4O)_eH$

wherein R is alkyl of 6-18 carbon atoms, alkylphenyl having an alkyl moiety of 4-20 carbon atoms or the group

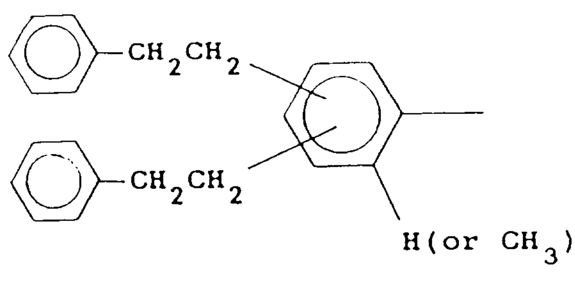

A is oxygen, sulfur or the group -COO, -CONH, $CON(C_2H_4O)_eH$, $PO_4H$ or $PO_4(C_2H_4O)_eH$, the symbols e, which may be the same or different, each representing an integer of 2-80, or

(iii) 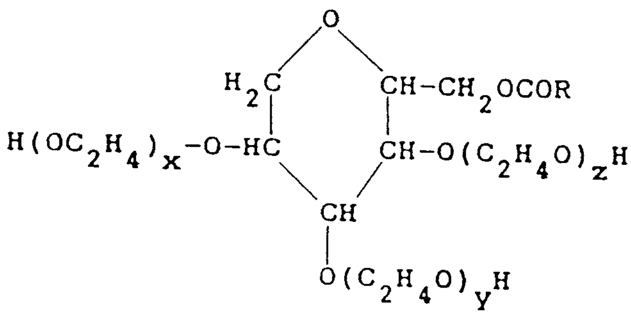

wherein R is an alkyl of 6-18 carbon atoms, and x, y and z are each an integer of 2-40.

**5.** A structure as claimed in either of claims 1 and 2 wherein said adhesive comprises (A) a water-soluble polymer derived from (meth)acrylic acid, (meth)acrylic ester, vinylpyrrolidone, acrylamide, dimethylaminoethyl (meth)acrylate, diethylamino(meth)acrylate, vinyl methyl ether or a (meth)acrylic ester monomer represented by the formula

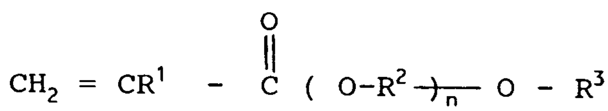

wherein $R^1$ is hydrogen or methyl, $R^2$ is an alkylene of 2-4 carbon atoms, $R^3$ is an alkyl of 1 or more carbon atoms, and n is an integer of 1 or more and (B) a (meth)acrylic ester monomer which gives a water-swelling polymer.

**6.** A structure as claimed in claim 5 wherein the (meth)acrylic ester monomer (B) is a (meth)acrylic ester monomer, dimethylaminoethyl(meth)acrylate or diethylaminoethyl(meth)acrylate.

**7.** A structure as claimed in either of claims 1 and 2 wherein said adhesive comprises (A) a salt of a copolymer obtained by neutralizing the carboxyl group in a copolymer comprising 10-40 mol% of a carboxyl-containing monomer, 60-90 mol% of (meth)acrylic alkyl ester having an alkyl moiety of 4 or more carbon atoms and 0-20 mo.% of vinyl monomer other than the above-mentioned monomers and (B) a hydrophilic compound represented by the formula $R_1O(R_2O)_nR_3$ wherein $R_1$ is an alkyl of 1-4 carbon atoms, $R_2$ is an alkylene of 2-4 carbon atoms, $R_3$ is hydrogen, an alkyl of 1-4 carbon atoms or acetyl, and n is an integer of 1-6.

**8.** Process for grinding the reverse side of a wafer said process comprising:
i) forming a structure as claimed in any one of claims 1 to 7;
ii) grinding the reverse side of said wafer with water spraying;
iii) stripping off said adhesive sheet after completion of grinding; and, where necessary
iv) removing any residual adhesive by water washing.

**Patentansprüche**

**1.** Temporäre Struktur, die ein Halbleiterplättchen umfaßt, das eine strukturierte Oberseite hat und einen daran angebrachten Klebestreifen zum Schutz der strukturierten Oberseite während des Schleifens der Rückseite des Plättchens, dadurch gekennzeichnet, daß der Klebestreifen aus einem Basisstreifen und einem wasserquellbaren wasserlöslichen Klebstoff besteht.

**2.** Struktur nach Anspruch 1, worin der Basisstreifen Polyethylen, Polypropylen, Polyvinylchlorid, Polyethylenterephthalat, Polybutylenterephthalat, Polybuten, Polybutadien, Polyurethan, Polymethylpenten, Ethylen-Vinylacetat-Copolymeres, vernetztes Polyolefin- oder Ethylen-Methacrylsäure-Copolymeres ist.

3. Struktur nach Anspruch 1 oder 2, worin der Klebstoff umfaßt (A) ein oder zwei oder mehrere nicht-ionische oberflächenaktive Mittel mit Ethylenoxidgruppen als deren hydrophile Komponenten, und (B) ein oder zwei oder mehrere Copolymere, bestehend aus 40 - 99 Mol-% einer oder zwei oder mehrerer sich wiederholender Struktureinheiten, die durch die folgende Formel (I) repräsentiert werden, und 60 - 1 Mol-% einer oder zwei oder mehrerer sich wiederholender Struktureinheiten, die durch die folgende Formel (II) repräsentiert werden, wobei das Copolymere oder die Copolymeren vernetzt sind, falls erforderlich, mit einem Vernetzer wie Zinkacetat oder Magnesiumchlorid, der mit der Carboxygruppe der Komponente (B) reagiert;

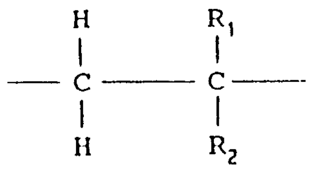

(I)

worin $R_1$ Wasserstoff, Chlor oder Niederalkyl ist, und $R_2$ ist Wasserstoff, Chlor, Niederalkyl oder eine Gruppe $-OCOR_3$, $-OR_3$, $-COOR_3$,

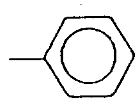 , 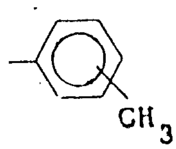 ,

$-CN$, $-CONH_2$, $-CONHCH_2OH$, $-CH_2OH$, $-C_2H_4OH$, $-OH$ oder

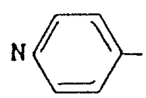

worin $R_3$ Alkyl mit 1 bis 8 Kohlenstoffatomen ist;

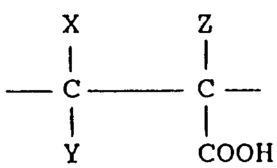

(II)

worin X, Y und Z, die gleich oder verschieden sein können, jeweils Wasserstoff, Chlor, Niederalkyl oder die Gruppe $-COOR_4$, $-COOH$, $-CH_2COOH$ oder $-CH_2COOR_4$ ist, worin $R_4$ Alkyl mit 1 bis 4 Kohlenstoffatomen ist.

4. Struktur nach Anspruch 3, worin die nicht-ionischen oberflächenaktiven Mittel

(i) $HO(C_2H_4O)_a(C_3H_6O)_b(C_2H_4O)_cH$

worin a, b und c jeweils eine ganze Zahl von 20 bis 80 darstellen,

(ii) $RA(C_2H_4O)_eH$

worin R Alkyl mit 6 bis 18 Kohlenstoffatomen, Alkylphenyl mit einem Alkylteil von 4 bis 20 Kohlenstoffatomen oder die Gruppe

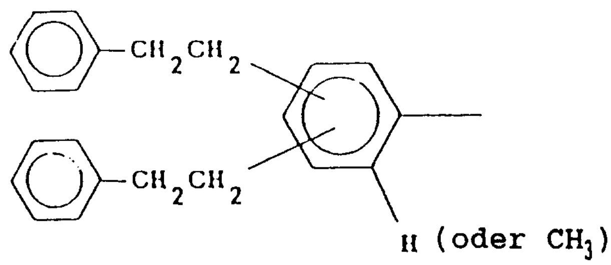

ist, A ist Sauerstoff, Schwefel oder die Gruppe -COO, -CONH, -CON($C_2H_4$)$_e$H, $PO_4H$ oder $PO_4(C_2H_4O)$-$_e$H, wobei die Symbole e, die gleich oder verschieden sein können, jeweils eine ganze Zahl von 2 bis 80 darstellen können, oder

(iii)

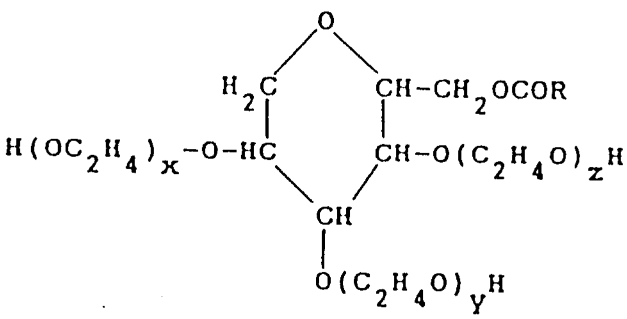

sind, worin R Alkyl mit 6 bis 18 Kohlenstoffatomen ist, und x, y und z jeweils eine ganze Zahl von 2 bis 40 darstellen.

**5.** Struktur nach Anspruch 1 oder 2, worin der Klebstoff umfaßt (A) ein wasserlösliches Polymeres, abgeleitet von (Meth)Acrylsäure, (Meth)Acrylester, Vinylpyrrolidon, Acrylamid, Dimethylaminoethyl-(meth)acrylat,Diethylamino-(meth)acrylat, Vinylmethylether oder ein (Meth)Acrylsäureester-Monomeres, das durch die Formel

$$CH_2 = CR^1 - \overset{\displaystyle O}{\overset{\|}{C}}\ (O-R^2-)_n - O - R^3$$

repräsentiert wird, worin $R^1$ Wasserstoff oder Methyl ist, $R^2$ ist Alkylen mit 2 bis 4 Kohlenstoffatomen, $R^3$ ist Alkyl mit einem oder mehreren Kohlenstoffatomen und n ist eine ganze Zahl von 1 oder mehr, und (B) ein (Meth)Acrylsäureester-Monomeres, woraus sich ein wasserquellbares Polymeres ergibt.

**6.** Struktur nach Anspruch 5, worin das (Meth)Acrylsäureester-Monomere (B) ein (Meth)Acrylsäureester-Monomeres, Dimethylaminoethyl(meth)acrylat oder Diethylaminoethyl(meth)acrylat ist.

**7.** Struktur nach Anspruch 1 oder 2, worin der Klebstoff umfaßt (A) ein Salz eines Copolymeren, erhalten durch Neutralisation der Carboxygruppe in einem Copolymeren, das aus 10 bis 40 Mol-% Carboxy-enthaltendem Monomeren, 60 bis 90 Mol-% (Meth)Acrylsäurealkylester, der einen Alkylteil mit 4 oder mehr Kohlenstoffatomen hat, und 0 bis 20 Mol-% Vinylmonomerem, das nicht zu den oben genannten Monomeren gehört, besteht, und (B) eine hydrophile Verbindung, die durch die Formel $R_1O(R_2O)_nR_3$ repräsentiert wird, worin $R_1$ Alkyl mit 1 bis 4 Kohlenstoffatomen ist, $R_2$ ist Alkylen mit 2 bis 4 Kohlenstoffatomen, $R_3$ ist Wasserstoff, Alkyl mit 1 bis 4 Kohlenstoffatomen oder Acetyl, und n ist eine ganze Zahl von 1 bis 6.

**8.** Verfahren zum Schleifen der Rückseite eines Plättchens, wobei das Verfahren umfaßt:
i) Bildung einer Struktur, wie in einem der Ansprüche 1 bis 7 beansprucht;

ii) Schleifen der Rückseite des Plättchens unter Wassersprühung;
iii) Abziehen der Klebestreifen nach Beendigung des Schleifens; und, falls erforderlich,
iv) Entfernung von restlichem Klebstoff durch Waschen mit Wasser.

## Revendications

**1.** Structure temporaire comprenant une pastille semiconductrice présentant une face à motifs et sur laquelle est fixée une feuille adhésive servant à protéger ladite face à motifs au cours du meulage de l'envers de ladite pastille, caractérisée en ce que ladite feuille adhésive comprend une feuille de base et un adhésif soluble dans l'eau et gonflable à l'eau.

**2.** Structure selon la revendication 1, dans laquelle ladite feuille de base est du polyéthylène, du polypropylène, du poly(chlorure de vinyle), du poly(téréphtalate d'éthylène), du poly(téréphtalate de butylène), du polybutène, du polybutadiène, du polyuréthanne, du polyméthylpentène, un copolymère éthylène-acétate de vinyle, une polyoléfine réticulée ou un copolymère éthylène-acide méthacrylique.

**3.** Structure selon l'une quelconque des revendications 1 et 2, dans laquelle ledit adhésif comprend (A) un ou plusieurs agents tensioactifs non ioniques possédant des groupes polyoxyéthylène comme constituants hydrophiles et (B) un ou deux, ou plus, copolymères composés de 40-99% en moles d'un ou de deux, ou plus, motifs récurrents représentés par la formule (I) suivante et de 60-1% en moles d'un ou de deux, ou plus, motifs récurrents représentés par la formule (II) suivante, ledit ou lesdits copolymères étant réticulés, le cas échéant, avec un agent de réticulation tel que l'acétate de zinc ou le chlorure de magnésium, qui réagit avec le groupe carboxyle du constituant (B) :

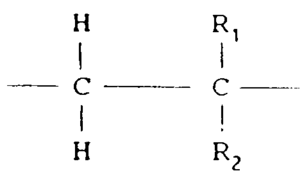 (I)

dans laquelle $R_1$ est un atome d'hydrogène, un atome de chlore, ou un groupe alkyle inférieur, et $R_2$ est un atome d'hydrogène, un atome de chlore ou un groupe alkyle inférieur ou $-OCOR_3$, $-OR_3$, $-COOR_3$,

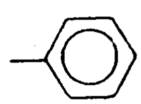 , 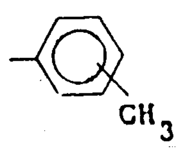 ,

$-CN$, $-CONH_2$, $-CONHCH_2OH$, $-CH_2OH$, $-C_2H_4OH$, $-OH$, ou N

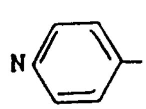

où $R_3$ est un groupe alkyle de 1-8 atomes de carbone;

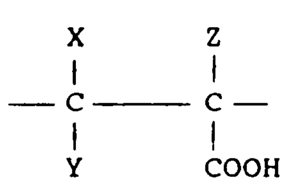 (II)

dans laquelle X, Y et Z, qui peuvent être identiques ou différents, sont chacun un atome d'hydrogène,

un atome de chlore ou un groupe alkyle inférieur ou $-COOR_4$, -COOH, $-CH_2COOH$ ou $-CH_2COOR_4$, où $R_4$ est un groupe alkyle de 1-4 atomes de carbone.

**4.** Structure selon la revendication 3, dans laquelle les agents tensioactifs non ioniques sont

(i) $HO(C_2H_4O)_a(C_3H_6O)_b(C_2H_4O)_cH$

dans laquelle a, b et c sont chacun un nombre entier de 20-80.

(ii) $RA(C_2H_4O)_eH$

dans laquelle R est un groupe alkyle de 6-18 atomes de carbone, alkylphényle dont le groupe alkyle possède de 4-20 atomes de carbone, ou le groupe

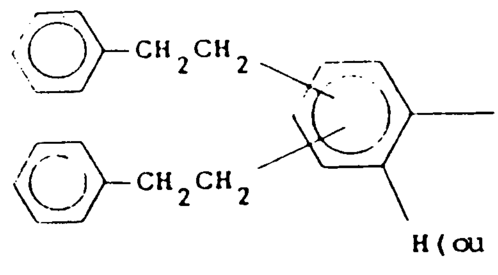

A est un atome d'oxygène, un atome de soufre, ou le groupe -COO, -CONH, $CON(C_2H_4O)_eH$, $PO_4H$ ou $PO_4(C_2H_4O)_eH$, les symboles e, qui peuvent être identiques ou différents, représentant chacun un nombre entier de 2-80.

(iii)

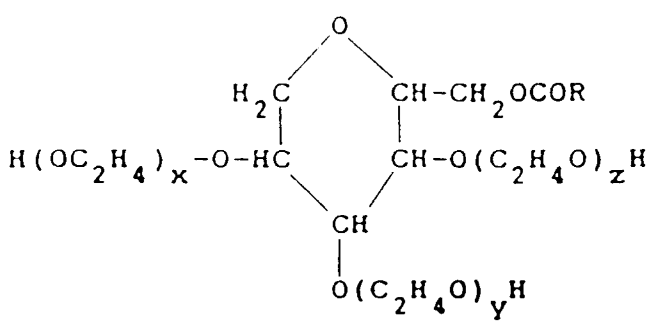

dans laquelle R est un groupe alkyle de 6-18 atomes de carbone et x, y et z sont chacun un nombre entier de 2-40.

**5.** Structure selon l'une quelconque des revendications 1 et 2, dans laquelle ledit adhésif comprend (A) un polymère soluble dans l'eau dérivé d'acide (méth)acrylique, d'ester (méth)acrylique, de vinylpyrrolidone, d'acrylamide, de (méth)acrylate de diméthylaminoéthyle, de (méth)acrylate de diéthylaminoéthyle, de vinylméthyléther ou d'un monomère ester (méth)acrylique représenté par la formule

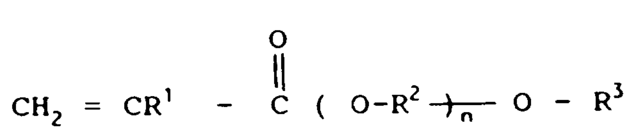

dans laquelle $R^1$ est un atome d'hydrogène ou un groupe méthyle, $R^2$ est un groupe alkylène de 2-4

atomes de carbone, $R^3$ est un groupe alkyle d'au moins 1 atome de carbone, et n est un nombre entier au moins égal à 1, et (B) un monomère ester (méth)acrylique qui donne un polymère gonflable à l'eau.

**6.** Structure selon la revendication 5, dans laquelle le monomère ester (méth)acrylique (B) est un monomère ester (méth)acrylique, un (méth)acrylate de diméthylaminoéthyle ou un (méth)acrylate de diéthylaminoéthyle.

**7.** Structure selon l'une quelconque des revendications 1 et 2, dans laquelle ledit adhésif comprend (A) un sel d'un copolymère, obtenu par neutralisation du groupe carboxyle dans un copolymère comprenant 10-40% en moles d'un monomère contenant un groupe carboxyle, 60-90% en moles d'ester alkylique d'acide (méth)acrylique possédant un groupe alkyle d'au moins 4 atomes de carbone et 0-20% en moles de monomère vinylique autre que les monomères mentionnés ci-dessus, et (B) un composé hydrophile représenté par la formule $R_1O(R_2O)_nR_3$, dans laquelle $R_1$ est un groupe alkyle de 1-4 atomes de carbone, $R_2$ est un groupe alkylène de 2-4 atomes de carbone, $R_3$ est un atome d'hydrogène ou un groupe alkyle de 1-4 atomes de carbone ou acétyle, et n est un nombre entier de 1-6.

**8.** Procédé de meulage de l'envers d'une pastille, ledit procédé comprenant :

i) la formation d'une structure selon l'une quelconque des revendications 1 à 7;
ii) le meulage de l'envers de ladite pastille avec une pulvérisation d'eau;
iii) le décollement de ladite feuille adhésive à l'issue du meulage; et, le cas échéant,
iv) l'élimination de tout adhésif résiduel par lavage à l'eau.

FIG. 1

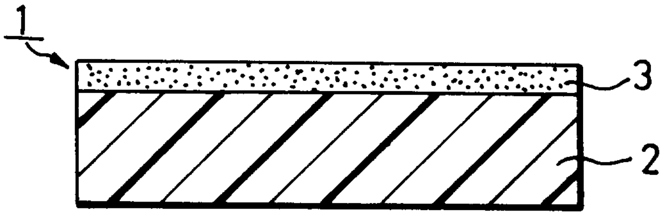


FIG. 2

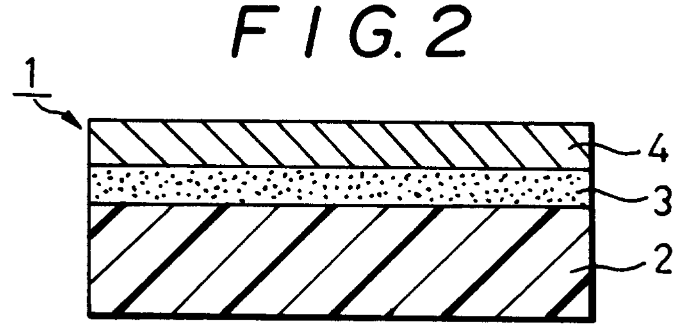


FIG. 3

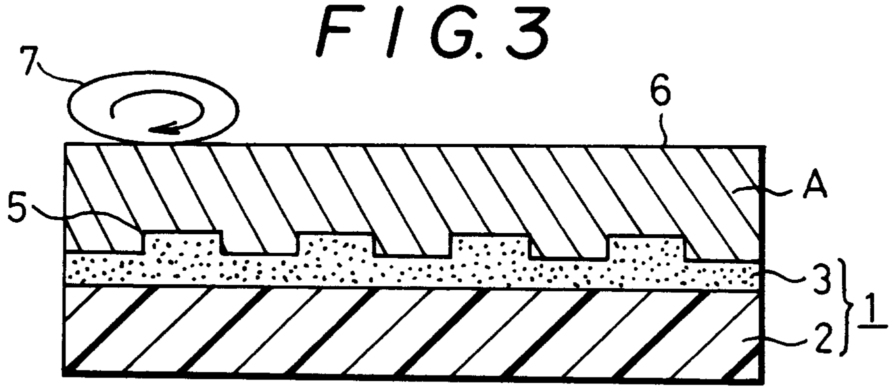


FIG. 4